# EUROPEAN PATENT SPECIFICATION

(11) **EP 4 312 037 B1**
(45) Date of publication and mention of the grant of the patent: **02.09.2026**
(21) Application number: 22186901.9
(22) Date of filing: 26.07.2022
(51) Int. Cl.: G01R 31/317, G01R 31/319, G01R 13/02, H04L 1/20, H04L 1/24

(54) **MEASUREMENT APPLICATION DEVICE AND METHOD**
MESSANWENDUNGSVORRICHTUNG UND VERFAHREN
DISPOSITIF ET PROCÉDÉ D'APPLICATION DE MESURE

(43) Date of publication of application: 31.01.2024
(73) Proprietor: Rohde & Schwarz GmbH & Co. KG, 81671 München (DE)
(72) Inventor: Holzleitner, Christoph, 80804 München (DE); Barthel, Sven, 09112 Chemnitz (DE); Kuellmer, Alexander, 75365 Calw (DE)
(74) Representative: Novagraaf Group

(56) References cited:
- US-A1- 2004 136 479
- US-A1- 2005 100 215
- US-A1- 2014 169 429
- US-A1- 2019 296 867
- US-A1- 2020 014 501
- US-B2- 6 791 545
- YUMINAKA YASUSHI ET AL: "PAM-4 Eye Diagram Analysis and Its Monitoring Technique for Adaptive Pre-Emphasis for Multi-valued Data Transmissions", 2017 IEEE 47TH INTERNATIONAL SYMPOSIUM ON MULTIPLE-VALUED LOGIC (ISMVL), IEEE, 22 May 2017 (2017-05-22), pages 13 - 18, XP033113863, [retrieved on 20170630], DOI: 10.1109/ISMVL.2017.29

## Description

### TECHNICAL FIELD

The disclosure relates to measurement application device and a respective method.

### BACKGROUND

Although applicable to any measurement device, the present disclosure will mainly be described in conjunction with measurement devices for measuring pulse amplitude modulated, PAM, signals.

When analyzing signals with multiple characterizing signal levels, like PAM signals, so called eye diagrams may be generated for analysis by a user.

With increasing number of signal levels, the space on a display of a measurement device may become small for displaying such an eye diagram. A user may in such cases not be able to identify the relevant details.

Document "PAM-4 Eye Diagram Analysis and Its Monitoring Technique for Adaptive Pre-Emphasis for Multi-Valued Data Transmissions" by Yuminaka et al., discloses how to optimize a transmitter equalizer for transmitting PAM signals using a modulo folded histogram. Document US 2014/0169429 A1 discloses a method for measuring jitter in a PAM transmitter. Document US 2020/0014501 A1 discloses an eye diagram measurement device. Document US 2019/0296867 A1 discloses a waveform observation system. Document US 6,791,545 B2 discloses how to display measurements of a waveform as icons on an oscilloscope. Document US 2004 / 0136479 A1 discloses how to display substantially noise-free segments of serial data waveforms. Document US 2005 / 0100215 A1 discloses how to re-align components of a composite eye-diagram according to an appropriate standard.

There is a need for improving the signal analysis capabilities of measurement devices.

### SUMMARY

The above stated problem is solved by the features of the independent claims. Further embodiments are defined in the dependent claims. Additionally the description and drawings also present examples, example embodiments, aspects, non-claimed embodiments, implementations, etc. for the better understanding of the embodiments disclosed by the appended claims.

The present disclosure is based on the finding that traditional eye diagrams may not be practical any more to analyze e.g., PAM signals, when too many signal levels are provided with the signal to be analyzed.

With eye diagrams multiple cycles or periods of a signal to be analyzed are overlaid over each other resulting in a diagram with multiple eyes that are formed between the characterizing signal levels of the respective signal. The eye diagrams allow analyzing the size of the eyes and identifying signal errors for example, signal traces that cross the area of an eye.

A signal with two characterizing signal levels will provide an eye diagram with a single eye that is formed between the two signal levels, while the eye will be limited by the traces of the signal level changes between the two signal levels.

A signal with three characterizing signal levels will provide an eye diagram with two eyes, a signal with four characterizing signal levels will provide an eye diagram with three eyes, and so on.

However, with an increasing number of eyes, the area of a display of a measurement device may not be sufficiently large for a user to identify all details of the eye diagram correctly. Instead of simply increasing the size of the display, the present disclosure provides an improved measurement application device.

The measurement application device according to the present disclosure comprises a signal interface for receiving the signal that is to be analyzed. The signal will comprise or be modulated with at least two characterizing signal levels. Possible signals may for example be pulse amplitude modulated and may be called PAM signals. PAM signals may also comprise an indication of the number of signal levels that are used in the respective PAM signal. Such PAM signals may be denoted as PAM-N signals, wherein N denotes the number of signal levels.

The signal analyzer that is coupled to the signal interface will analyze the received signal, and determine individual sub-diagrams for the received signal. The sub-diagrams at least comprise eye diagrams and/or jitter diagrams.

After determining the sub-diagrams, the diagram processor will arrange the sub-diagrams in a respective diagram arrangement. The diagram arrangement comprises for each one of the sub-diagrams a respective position indicator that indicates the position of the respective sub-diagram in the diagram arrangement. The positions may for example, be indicated by a respective ordinal number.

The diagram arrangement is provided as a three-dimensional arrangement such that the sub-diagrams are arranged around a main axis of the three-dimensional arrangement with one of their axes in parallel to the main axis.

It is understood, that the term "three-dimensional arrangement" in this context may refer to a virtual arrangement, wherein the sub-diagrams are at least assigned a position in the virtual arrangement. The diagram processor not necessarily needs to calculate a real three-dimensional visual representation of the sub-diagrams in the three-dimensional arrangement.

The main axis of the three-dimensional arrangement may for example comprise the vertical axis or the horizontal axis of the three-dimensional arrangement. At the same time, the axis of each one of the sub-diagrams that is arranged in parallel to the main axis may be the vertical axis or the horizontal axis of the respective sub-diagram.

After arranging the sub-diagrams in the three-dimensional arrangement, the display shows at least one of the sub-diagrams of the diagram arrangement to a user. Showing or displaying at least part of the diagram arrangement on the display may refer to showing one or multiple of the sub-diagrams to the user.

The user may then influence the displaying of the diagram arrangement on the display via the user input. If each one of the sub-diagrams is assigned a position or ordinal number, the user may for example use the user input to cycle through the single sub-diagrams on the display.

When showing the diagram arrangement as a three-dimensional arrangement to the user a predefined display plane is shown to the user that is arranged with a respective relative position to the three-dimensional arrangement. In further implementations, the vertical axis of the display plane may for example be arranged in parallel to the vertical axis of the three-dimensional arrangement. In addition, or as alternative, the horizontal axis of the display plane may be arranged in parallel to the horizontal axis of the three-dimensional arrangement. The graphics processor may for example, control the display to display one of the sub-diagrams in the display plane.

With the user input, a user may then control the graphics processor to display other sub-diagrams for example, by rotating the three-dimensional arrangement around the main axis or around any other axis of the three-dimensional arrangement. By rotating the three-dimensional arrangement around the main axis, the user may for example, bring to the front different ones of the sub-diagrams.

If the positions are denominated by ordinal numbers, the sub-diagrams assigned to the ordinal numbers may simply be cycled through according to the ordinal numbers upon a respective user input.

It is understood, that the user interface may comprise any type of input device that may be actuated by a user. Such a user interface may comprise a user interface of the measurement application device or an external user interface. Exemplary input devices may for example comprise at least one of keys, buttons, a mouse, a keyboard, a touch panel, and a touch pad.

Of course, the measurement application device may also offer the user a traditional eye diagram style display. However, with the measurement application device according to the present disclosure, a user may flexibly view any of the sub-diagrams as required. Instead of viewing a single diagram like, an eye diagram, the user may individually view each one of the sub-diagrams and analyze the respective details.

With the features of the present disclosure the measurement application device implements a kind of interactive filter that allows the user to interactively select the sub-diagram that the user wants to analyze in detail.

It is understood, that the measurement application device may be provided as a dedicated device. In other embodiments, the measurement application device or at least some of the elements of the measurement application device may be implemented in a measurement device as an addition to the functionality of the measurement device. In another embodiment, the functionality of the measurement application device may be implemented in a computer device.

The signal analyzer and the diagram processor may each be provided as a dedicated processing element, like e.g., a processing unit, a microcontroller, a field programmable gate array, FPGA, a complex programmable logic device, CPLD, or the like. The signal analyzer and the diagram processor may at least in part also be provided as a computer program product comprising computer readable instructions that may be executed by a processing element. In a further embodiment, the signal analyzer and the diagram processor may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them.

In addition, it is understood, that any required supporting or additional hardware may be provided like e.g., a power supply circuitry and clock generation circuitry.

The signal interface may also be provided as an interface of a respective measurement device that comprises the measurement application device. The signal interface in such implementations may be provided as a signal acquisition interface of the measurement device.

As alternative, the signal interface may comprise any kind of wired and wireless communication interfaces, like for example a network communication interface, especially an Ethernet, wireless LAN or WIFI interface, a USB interface, a Bluetooth interface, an NFC interface, a visible or non-visible light-based interface, especially an infrared interface.

Further embodiments of the present disclosure are subject of the further dependent claims and of the following description, referring to the drawings.

In an embodiment, the diagram arrangement comprises predetermined diagram positions. The diagram processor is configured to assign each of the sub-diagrams to one of the predetermined diagram positions.

The diagram positions may each refer to a position of the diagram in a one-dimensional list or in a two-dimensional list or matrix.

Such a list may refer to a sequence in which the sub-diagrams are arranged and may be displayed to the user. If for example a first sub-diagram and a second sub-diagram are positioned in consecutive diagram positions in the list, the first sub-diagram may first be displayed. The second sub-diagram may then be displayed to the user, after a user input to display the sub-diagram at the next position is received by the measurement application device.

In an implementation with a two-dimensional list, the user may provide inputs regarding the two axis or dimensions of the list separately.

The diagram processor may in each case control the display to show the currently selected sub-diagram to the user.

As explained above, the diagram arrangement is provided in the form of a three-dimensional arrangement. In such an embodiment, the diagram positions in the list may refer to the positions of the sub-diagrams in the three-dimensional arrangement. Such a list may be a three-dimensional list or array if required.

In another embodiment, the diagram processor is configured to determine the sub-diagrams as at least one of eye diagrams and histograms.

As indicated above, the traditional way of analyzing PAM-N signals is the use of a standard eye diagram that display a respective portion of the PAM-N signal to be analyzed.

With the diagram processor according to the present disclosure, it becomes possible to generate sub-diagrams of such a traditional eye diagram that may then be analyzed individually.

The possibility to also provide histograms or other diagram types, allows easily providing multiple types of different information to a user. As with the eye diagrams, the present disclosure also allows generating sub-histograms as sub-diagrams for example, for the signal parts of the signal to be analyzed that form a single eye or that comprise a specific level step or level change.

Sub-diagrams that comprise histograms may provide a histogram for a respective eye-diagram. Such a histogram may for example show the accumulated number of signal values on a time axis for multiple periods of the signal to be analyzed, and for a signal level that represents the center of a respective eye-diagram.

Other sub-diagrams that represent histograms may refer to jitter in the signal to be analyzed. A sub-diagram may for example represent the total jitter, another sub-diagram may represent the data-dependent jitter, another diagram may represent the random jitter, and another diagram may represent the periodic jitter in the signal.

In yet another embodiment, the diagram processor may be configured to determine at least one of the sub-diagrams for a signal level change that is greater than a single level step in the received signal.

In a PAM-4 signal, there exist 4 different signal levels, level 0, level 1, level 2, and level 3. Consequently, there exist six possible level steps or level changes. Level step 0-1, level step 1-2, level step 2-3, level step 0-2, level step 0-3, level step 1-3. Of course, the start section of an eye may comprise another level step than the end section of an eye. In such cases, the signal analyzer may in embodiments only take into account the signal parts that form part of the eye-diagram that is to be generated and ignore other signal parts.

In conventional eye diagrams, all the level steps that occur in the signal to be analyzed are all shown concurrently in a single eye diagram.

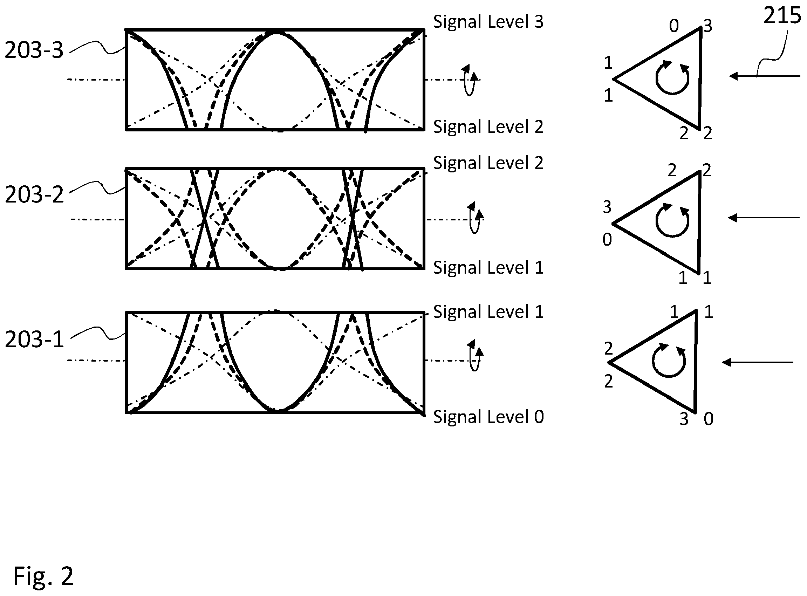

The measurement application device of the present disclosure in contrast allows generating single eye diagrams as sub-diagrams. Such sub-diagrams may comprise a single "eye" of a traditional eye diagram i.e., an eye diagram for a level change between two adjacent signal levels. In the case of a PAM-4 signal, the number of eyes in a traditional eye diagram is three. Therefore, the number of sub-diagrams according to the present disclosure may be three for a PAM-4 signal, as is for example shown in Figure 2. In general, the number of sub-diagrams for any PAM-N signal may be N-1. The signal analyzer may in such an embodiment determine N-1 sub-diagrams. Each of these sub-diagrams may in embodiments comprise a section of a traditional eye diagram that represents a single eye of that diagram.

In embodiments, the sub-diagrams according to the present disclosure may also comprise an eye-diagram for a step or level change that spans more than two adjacent signal levels for example, the above-mentioned level step 0-2, level step 0-3, and level step 1-3.

In a further embodiment, the diagram processor is configured to control the display to display at least one sub-diagram comprising an eye-diagram and at least one sub-diagram comprising a histogram.

In embodiments that display eye-diagrams with histograms at the same time on the display, the user is provided with enhanced analysis capabilities. The user may for example analyze a specific "eye" or level step visually in the eye-diagram and may at the same time inspect the respective histogram.

In implementations, in which sub-diagrams of other types and histograms are provided on the display at the same time, the histograms may be shown for the sub-diagrams that are currently shown. A totally independent display of sub-diagrams and histograms is also possible.

In another embodiment, the diagram positions may comprise consecutive diagram positions, and the diagram processor may be configured to assign consecutive positions to sub-diagrams that refer to adjacent level steps in the received signal. The diagram processor may be configured to control the display to display the next sub-diagram according to the sequence of the positions upon receiving a respective user input.

The single sub-diagrams may, as indicated above, each display one of the eyes of a traditional eye diagram. In a PAM-4 signal the three eyes refer to the levels 0-1, 1-2, and 2-3. In this embodiment, three sub-diagrams may be provided, a first sub-diagram for levels 0-1, a second sub-diagram for levels 1-2, and third sub-diagram for levels 2-3.

The sub-diagrams may be arranged in consecutive positions according to their sequence, the first sub-diagram on the first position, the second sub-diagram on the second position, and the third diagram on the third position.

The user may now cycle through the positions, and the respective sub-diagram may be shown in each case to the user.

If for example, the main axis is the horizontal axis and the sub-diagrams are arranged with their respective horizontal axis in parallel to the main axis, the single sub-diagrams may be arranged in a drum-like arrangement around the main axis or may each extend form the main axis in a star-like arrangement. A combination of both is of course possible. The same applies analogously to the vertical axis.

In yet another embodiment, the diagram positions may refer to angular positions, and the diagram processor may be configured to assign a different angular position to each one of the sub-diagrams. The diagram processor may also be configured to control the display to display the sub-diagrams as lines in a circular diagram with a common center point based on the assigned angular positions.

The circular diagram may be seen as diagram similar to a polar-coordinate diagram, wherein the sub-diagrams that are provided as eye-diagrams may be shown as lines, as if the two-dimensional eye-diagrams were viewed in top view.

The circular diagram may have a center point and concentric circles around the center point, wherein each of the circles has a radius that represents one of the signal levels of the signal to be analyzed. The center point may for example represent signal level 0, the first circle may represent signal level 1, the second circle may represent signal level 2, and so on.

Sub-diagrams that comprise an eye-diagram may be included in the circular diagram as lines that extend between the circles that represent the signal levels for the respective eye-diagram and point to the center point.

An eye diagram for a level step from level 1 to level 2 may for example be shown as a line between the first circle and the second circle. An eye diagram for a level step from level 0 to level 2 may for example be shown as a line between the center point and the second circle.

The angular positions for the single lines that each represent a sub-diagram may be predetermined or may be user-configurable. For example, the angle of 0° may be defined from the center point vertically to the top. If three sub-diagrams are to be included in the circular diagram, a first sub-diagram may be included as a line oriented at 0°, the second sub-diagram may be included as a line oriented at 120°, and the third sub-diagram may be included as a line oriented at 240°. If more than three sub-diagrams are to be included, any number of sub-diagrams may be evenly distributed around the 360° of the circular diagram.

In other embodiments, the sub-diagrams that are to be included in the circular diagram may represent histograms. As explained above, such histograms may also represent a jitter in the signal to be analyzed.

Each of the sub-diagrams that represent such a jitter may be shown as a line in the circular diagram. In addition, the lines may be color coded, the color representing the value of the curve of the respective jitter diagram. Of course, the values may be quantized into a predetermined number of bins, and a respective number of colors may be used i.e., one color for each bin. As alternative, the color may gradually vary according to the value of the curve of the histogram. The distribution of the sub-diagrams in the circular diagram may be organized as explained above, by dividing the available 360° by the number of sub-diagrams that are to be included.

In a further embodiment, the diagram processor may be configured to control the display to display at least two sub-diagrams next to each other in two sections, and especially to overlay multiple sub-diagrams in at least one of the sections.

The display may be provided with two sections. In the two sections, different sub-diagrams may be displayed in an overlaying fashion. That means that for example, selected sub-diagrams that show eye-diagrams for specific level steps may be overlayed in one section, and other sub-diagrams that show eye-diagrams for other level steps may be overlayed in the other section.

In further embodiments, the diagram processor may also provide three or more sections to combine for example, two sections comprising eye-diagrams and a third section comprising a histogram for the respective eye-diagrams.

Further, in embodiments, the diagram processor may also display a circular diagram including multiple eye-diagrams in one of the sections. Any other type of diagram that combines multiple sub-diagrams into a single diagram may also be displayed in one of the sections.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a measurement application device according to the present disclosure;
Figure 2 shows a schematic view of an embodiment of a possible arrangement as displayed by an embodiment of a measurement application device according to the present disclosure;
Figure 3 shows a schematic view of an embodiment of a possible circular diagram as displayed by an embodiment of a measurement application device according to the present disclosure;
Figure 4 shows a schematic view of another embodiment of a possible circular diagram as displayed by an embodiment of a measurement application device according to the present disclosure;
Figure 5 shows a schematic view of another embodiment of a possible circular diagram as displayed by an embodiment of a measurement application device according to the present disclosure;
Figure 6 shows a schematic view of another embodiment of a possible circular diagram with histograms as displayed by an embodiment of a measurement application device according to the present disclosure;
Figure 7 shows a schematic view of another embodiment of a possible circular diagram with histograms as displayed by an embodiment of a measurement application device according to the present disclosure;
Figure 8 shows a flow diagram of an embodiment of a method according to the present disclosure; and
Figure 9 shows a block diagram of an embodiment of an oscilloscope that may be used as an embodiment of a measurement application device according to the present disclosure.

In the figures like reference signs denote like elements unless stated otherwise.

### DETAILED DESCRIPTION OF THE DRAWINGS

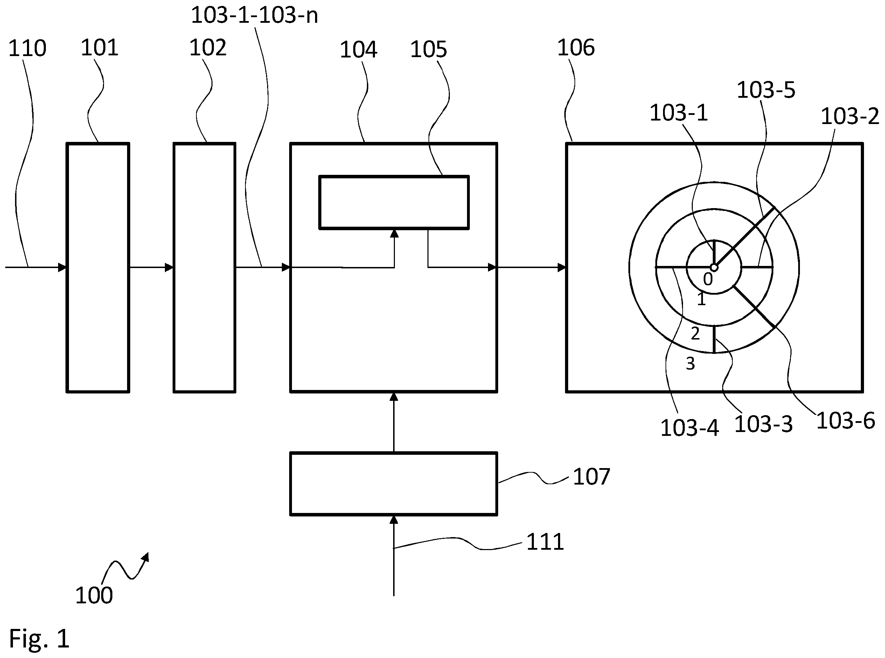

Figure 1 shows a block diagram of an embodiment of a measurement application device 100. The measurement application device 100 comprises a signal interface 101 that is coupled to a signal analyzer 102. The signal analyzer 102 is coupled to a diagram processor 104 that is coupled to a display 106. Further, a user interface 107 is coupled to the diagram processor 104.

The signal interface 101 receive a signal 110 that comprises at least two characterizing signal levels. Two characterizing signal levels may refer to each one of the signal levels representing specific data, like for example in PAM signals.

The signal 110 is provided to the signal analyzer 102 that analyzes the received signal 110 to determine individual sub-diagrams 103-1 - 103-n for the received signal 110. The sub-diagrams 103-1 - 103-n may for example each comprise one of an eye-diagram, a histogram or other types of diagrams for at least parts of the signal 110. A sub-diagram may for example be provided only for specific level changes or level steps in the signal, as will be explained in more detail below.

The diagram processor 104 arranges the individual sub-diagrams 103-1 - 103-n in a diagram arrangement 105. The term diagram arrangement 105 may for example, refer to a data structure that defines positions for the single sub-diagrams 103-1 - 103-n relative to each other.

Each one of the sub-diagrams 103-1 - 103-n may comprise a predefined content. The content of each one of the sub-diagrams 103-1 - 103-n may for example, be defined by the manufacturer of the measurement application device 100. Further, it may be predefined, what content is to be assigned to what position. For example, the first sub-diagram 103-1 may be defined to be an eye-diagram for a level change or level step from level 0 to level 1, also called step 0-1. The second sub-diagram 103-2 may be defined to be an eye-diagram for a level change or level step from level 1 to level 2, also called step 1-2, and so on. The first sub-diagram 103-1 may now be assigned to a first position, the second sub-diagram 103-2 may be assigned to a second position and so on.

The positions may be defined in a one-dimensional list or in a two-dimensional list or array, or even in a three-dimensional list or array.

The diagram processor 104 further controls the display 106 to display at least one of the sub-diagrams 103-1 - 103-n on display 106. It is understood, that the diagram processor 104 may control the display to display additional information and user interface elements on the display. When in this disclosure it is stated that the diagram processor 104 displays, it is understood, that the display is controlled by the diagram processor 104 to provide a corresponding display.

A user may provider user input 111 via user interface 107 with regard to the diagram arrangement 105 or the displaying of the diagram arrangement 105. The user input may for example indicate that the sub-diagrams 103-1 - 103-n of the next or previous position is to be displayed. Of course, the user input 111 may refer to any one of the dimensions that the positions may be defined for, as indicated above.

The diagram processor 104 then controls the displaying of the diagram arrangement 105 on the display 106 according to the user input 111.

The diagram processor 104 may simply switch the displayed sub-diagram 103-1 - 103-n or sub-diagrams 103-1 - 103-n. In other embodiments, the diagram processor 104 may switch the content of the display 106 with a respective animation, like rolling the display content in the respective direction. Such an animation not only pleases the user, such an animation also indicates to the user in which direction with regard to the positions the displaying is switched and allows easier orientation for the user.

In the measurement application device 100 the display 106 shows a circular diagram. The circular diagram comprises a center point and three concentric circles. The center point refers to signa level 0, the first circle refers to signal level 1, the second circle refers to signal level 2, and the third circle refers to signal level 3.

In the circular diagram sub-diagrams 103-1 - 103-6 are shown as lines extending between the center point and the circles or between the circles.

As indicated above, the signal 110 may be a PAM signal. In the circular diagram, the sub-diagrams 103-1 - 103-6 are shown for a PAM-4 signal.

The sub-diagram 103-1 refers to the eye for level 0-1, sub-diagram 103-2 refers to the eye for level 1-2, sub-diagram 103-3 refers to the eye for level 2-3, sub-diagram 103-4 refers to the eye for level 0-2, sub-diagram 103-5 refers to the eye for level 0-3, and sub-diagram 103-6 refers to the eye for level 1-2.

The sub-diagrams 103-1 - 103-4 are distributed evenly with a 90° between them in each case. The further sub-diagrams 103-5 - 103-6 are then shown with a 90° angle between them and with a 45° shift with regard to sub-diagrams 103-1 - 103-4.

Of course, in other embodiments, other angles may be chosen or the angles may be user-configurable. Further, the user interface 107 may offer the user the possibility to select which ones of the sub-diagrams 103-1 - 103-n are to be shown on the display 106.

The sub-diagrams 103-1 - 103-6 are shown as lines in the circular diagram because the circular diagram includes the sub-diagrams 103-1 - 103-6 viewed from the top, while the sub-diagrams 103-1 - 103-6 may be two-dimensional diagrams when viewed from the front.

Figure 2 on the left side shows a schematic view of a possible arrangement as it may be displayed for example on the display 106 of a measurement application device 100.

The arrangement of Figure 2 comprises three sub-diagrams 203-1 - 203-3. The first sub-diagram 203-1 shown on the bottom refers to the signal part of a signal to be analyzed between signal level 0 and signal level 1. The second sub-diagram 203-2 shown in the center refers to the signal part of a signal to be analyzed between signal level 1 and signal level 2. The third sub-diagram 203-3 shown on the top refers to the signal part of a signal to be analyzed between signal level 2 and signal level 3.

In each one of the three sub-diagrams 203-1 - 203-3 different signal curves are shown. The solid lines refer to signal parts spanning over all three sub-diagrams 203-1 - 203-3. The dashed lines refer to signal parts spanning over two of the sub-diagrams 203-1 - 203-3. Finally, the dashed-dotted lines refer to signal parts that span only over one of the sub-diagrams 203-1 - 203-3.

On the right, Figure 2 shows the three sub-diagrams 203-1 - 203-3 as they may be virtually arranged in a diagram arrangement, while arrow 215 indicates the viewing direction from which a user views the diagram arrangement.

The diagram arrangement may be thought of as a drum-like arrangement, that comprises the three sub-diagrams 203-1 - 203-3 as outer surface of the drum. When rotating the drum around the longitudinal axis the sub-diagrams 203-1 - 203-3 may be cycled through on the display. The longitudinal axis is the horizontal axis on the right of Figure 2, and the axis showing into the image on the right side of Figure 2.

If the diagram arrangement as shown in Figure 2 is shown to a user on a display of a measurement application device, the user may individually inspect the single level steps easily on the full area of the display.

The three single sub-diagrams 203-1 - 203-3 internally may each consist of an overlay of multiple sub-diagrams. For example, the respective signal analyzer may generate a single sub-diagram for the raising and the falling parts of the signal. Further, the signal analyzer may generate dedicated sub-diagrams for each possible level step i.e., level step 0-1, level step 1-2, level step 2-3, level step 0-2, level step 0-3, and level step 1-3. The user may then be offered a possibility to chose which of the generated sub-diagrams should be included in the sub-diagrams 203-1 - 203-3 that are shown on the display. It is understood, that single sub-diagrams may be overlayed

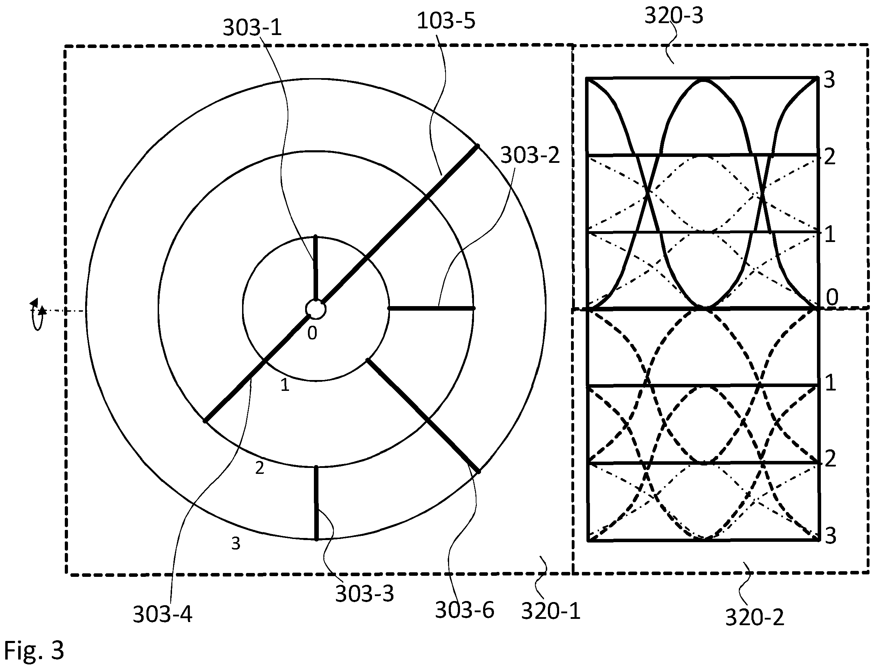

Figure 3 shows a schematic view of another possible circular diagram. The circular diagram of Figure 3 is based on the circular diagram of Figure 1 and comprises three sections 320-1, 320-2, 320-3. The sections 320-1, 320-2, 320-3.

The first section 320-1 is arranged on the left, while the second and third sections 320-2, 320-3 are arranged one over the other and right of the first section 320-1.

In the first section 320-1 the circular diagram of Figure 1 is shown in detail with the same lines or sub-diagrams 303-1 - 303-6. Reference is, therefore, made to the explanations provided with regard to Figure 1.

In the second section 320-2, on the lower right side of the first section 320-1, a four-level eye-diagram is shown, wherein the horizontal lines in the eye-diagram correspond to the circles of the circular diagram. Consequently, the top line refers to signal level 0, the second line from the top refers to signal level 1, the third line from the top refers to signal level 2, and the fourth line from the top refers to signal level 3.

In the eye-diagram of section 320-2 only those signal lines are shown that correspond to sub-diagrams 303-3, 303-4, and 303-6, which are arranged in the circular diagram on the lower half of the circles.

In the third section 320-3, on the upper right side of the first section 320-1, another four-level eye-diagram is shown, wherein the horizontal lines in the eye-diagram correspond to the circles of the circular diagram. Consequently, the bottom line refers to signal level 0, the second line from the bottom refers to signal level 1, the third line from the bottom refers to signal level 2, and the fourth line from the bottom refers to signal level 3.

In the eye-diagram of section 320-3 only those signal lines are shown that correspond to sub-diagrams 303-1, 303-2, and 303-5, which are arranged in the circular diagram on the upper half of the circles. While sub-diagram 303-2 is horizontally arranged in the circular diagram, it is still shown in the upper section 320-3, such that the same number of sub-diagrams is included in both sections.

A user may also provide user input to modify the displayed arrangement. The user may for example provide user input to turn the circular diagram. While turning the circular diagram, the sections 320-2, and 320-3 may be adapted accordingly, to show the corresponding eye diagrams.

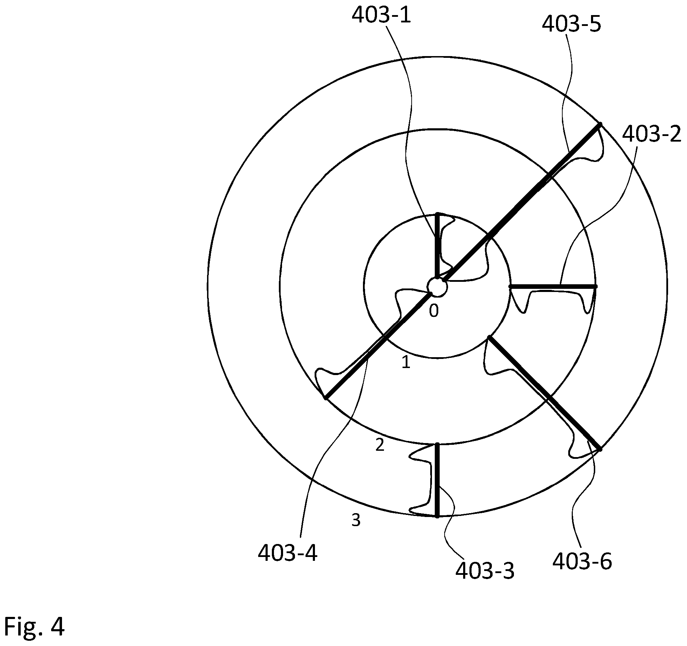

Figure 4 shows a schematic view of another circular diagram. The circular diagram of Figure 4 is based on the circular diagram as shown in Figure 1. However, the single lines that represent the sub-diagrams 403-1 - 403-6 in the circular diagram are enhanced with a histogram.

The histograms may be generated as further sub-diagrams by the signal analyzer and may be combined with the eye-diagram-representing sub-diagrams into sub-diagrams 403-1 - 403-6.

The histograms may be shown as curves, or alternatively as bars, that extend from the line representing the respective one of the sub-diagrams 403-1 - 403-6, as if the line was the horizontal line of a histogram diagram, while the plane in which the circular diagram is provided is the drawing plane of the histogram diagram.

It is understood, that the circular diagram as shown in Figure 4 may be combined with any of the other types of displaying the sub-diagrams or the diagram arrangement as disclosed herein.

The circular diagram as shown in Figure 4 may for example, be combined with the embodiment of Figure 3 by replacing the circular diagram of Figure 3 with the circular diagram of Figure 4. The histogram-carrying circular diagram may also be shown in addition to other diagrams, for example to the left of the circular diagram of Figure 3.

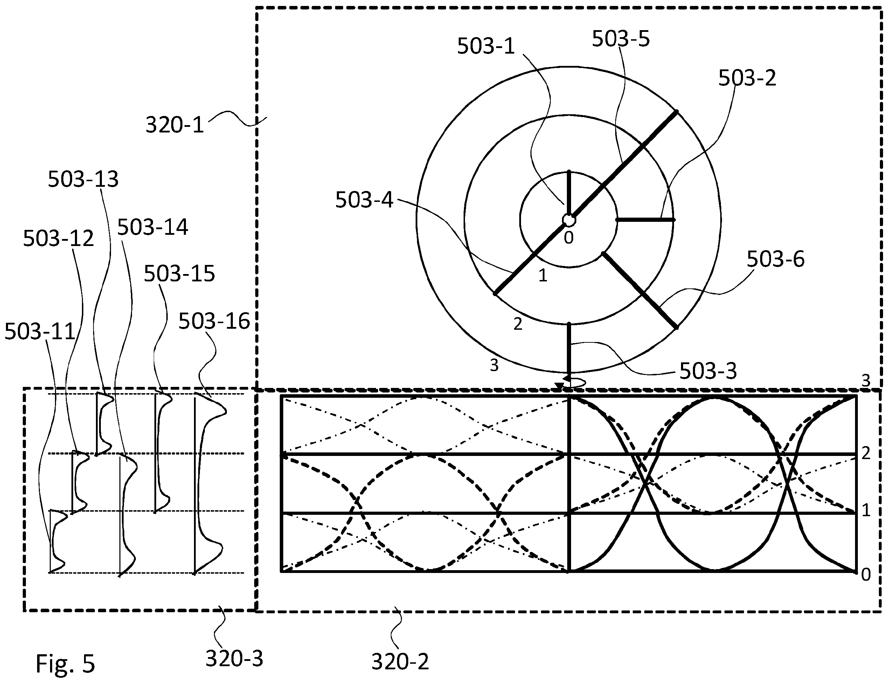

Figure 5 shows a schematic view of another possible arrangement as it may be shown on a display of a measurement application device according to the present disclosure.

The arrangement shown in Figure 5 comprises three sections, an upper section 520-1, a lower section 520-2 below the upper section, and a side section 520-3 with the height of the lower section 502-2 and placed left of the lower section 502-2.

The upper section 520-1 shows a circular diagram as it is also shown in Figure 1. The lower section 502-2 shows two eye-diagrams next to each other. The center line between the two eye-diagrams lies on a vertical line with the center point of the circular diagram. As with the eye-diagrams in Figure 3, the eye-diagrams comprise the single sub-diagrams 503-1 - 503-6 that in the circular diagram are provided on the respective side of the circular diagram.

Therefore, the left eye-diagram comprises sub-diagram 503-3, sub-diagram 503-4, and sub-diagram 503-1. The right eye-diagram comprises sub-diagram 503-2, sub-diagram 503-5, and sub-diagram 503-6. A user may provide a user input to turn the circular diagram. In that case, the sub-diagrams 503-1 - 503-6 may be rearranged in the left and right eye-diagram accordingly.

The side section 520-3 comprises multiple sub-diagrams 503-11 - 503-16 that each comprise a histogram, wherein sub-diagram 503-11 comprises the histogram for eye-diagram 503-1, sub-diagram 503-12 comprises the histogram for eye-diagram 503-2, and so on.

It is understood, that a user may select which types of diagrams should be shown on the display and may freely configure and combine any of the elements as disclosed for the arrangements of this disclosure.

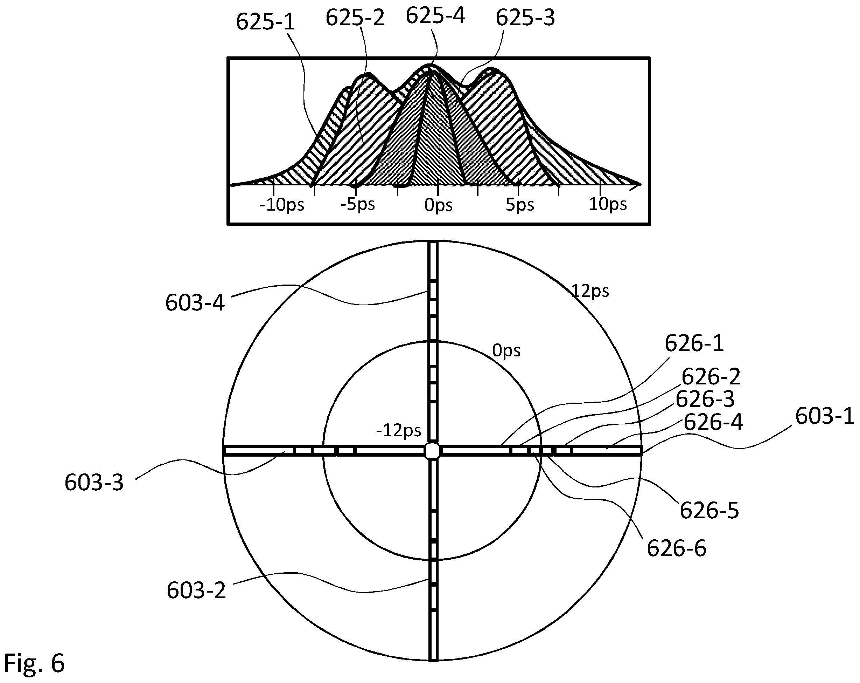

Figure 6 shows a schematic view of another circular diagram. The circular diagram of Figure 6 comprises histograms instead of eye-diagrams. The histograms that form the basis for the circular diagram are shown over the circular diagram. A histogram 625-1 may for example refer to the total jitter in a signal. The histogram 625-2 may for example refer to data-dependent jitter in a signal. The histogram 625-3 may for example refer to the random jitter in a signal. The histogram 625-4 may for example refer to the periodic jitter in a signal. The signal may for example be a PAM signal or a NRZ signal, also called "non return to zero signal". In an embodiment, each one of the histograms 625-1 - 625-4 may be determined by the signal analyzer as respective sub-diagrams 603-1 - 603-4.

The center of the histograms may represent a jitter of 0 ps (picoseconds). Exemplarily, the histograms 625-1 - 625-4 may show jitter from about -12 ps to about +12 ps.

In the circular diagram the center point may represent the -12 ps and an outer circle may represent +12 ps. A center circle may represent 0 ps.

In the circular diagram the single sub-diagrams may be shown as lines that are evenly distributed around the 360° of the circular diagram.

In embodiments, the lines representing the sub-diagrams 603-1 - 603-4 may be solid lines. In Figure 6, however, the single lines comprise sections 626-1 - 626-6 that may be colored or filled with a respective pattern, wherein the color or pattern may indicate a respective value of the histogram at the respective picosecond value. For sake of clarity only the sections of the right line in the circular diagram are provided with reference signs.

The circular diagram may be combined with further diagrams. The single histograms may for example, be shown below or next to the circular diagram, as exemplified for the eye-diagrams in Figures 3 and 5. Further, the user may provide user input to rotate the circular diagram or to overlay multiple of the histograms 625-1 - 625-4 or the respective sub-diagrams 603-1 - 603-6 in the diagrams displayed next to or below or above the circular diagram.

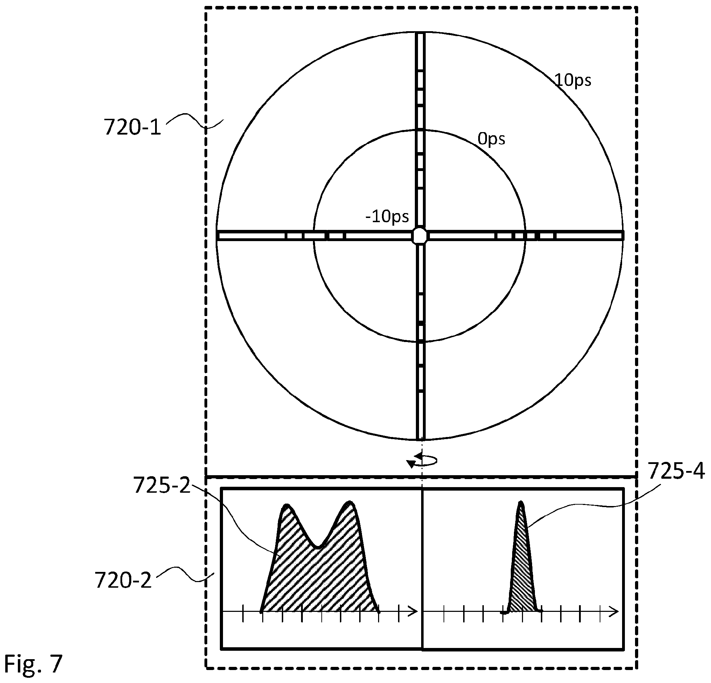

Figure 7 shows the circular diagram of Figure 6 in an upper section 720-1, and a lower section 720-2 with a sub-diagram on the left that comprises a histogram 725-2, and with a sub-diagram on the right that comprises a histogram 725-4. The histogram 725-2 is the same as histogram 625-2 of Figure 6, and the histogram 725-4 is the same as histogram 625-4 of Figure 6.

When the user rotates the circular diagram, the shown histograms in the lower section 720-2 may be updated accordingly. The user may also choose to overlap multiple histograms in the left and right sub-diagrams.

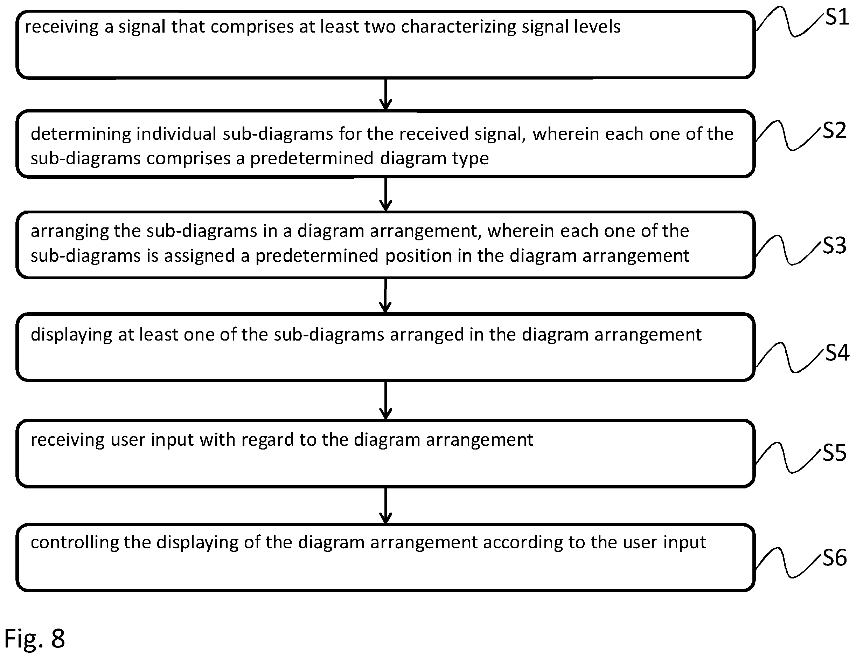

For sake of clarity in the following description of the method-based Figure 8 the reference signs used above in the description of apparatus-based Figures 1 - 7 will be maintained.

Figure 8 shows a flow diagram of a data processing method. The data processing method comprises receiving S1 a signal 110 that comprises at least two characterizing signal levels, determining S2 individual sub-diagrams 103-1 - 103-n, 203-1 - 203-3, 303-1 - 303-6, 403-1 - 403-6, 503-1 - 503-6, 603-1 - 603-6 for the received signal 110, wherein each one of the sub-diagrams 103-1 - 103-n, 203-1 - 203-3, 303-1 - 303-6, 403-1 - 403-6, 503-1 - 503-6, 603-1 - 603-6 comprises a predetermined diagram type, especially an eye diagram or a histogram 625-1, 625-2, 623-3, 625-4, 725-2, 725-4, arranging S3 the sub-diagrams 103-1 - 103-n, 203-1 - 203-3, 303-1 - 303-6, 403-1 - 403-6, 503-1 - 503-6, 603-1 - 603-6 in a diagram arrangement 105, wherein each one of the sub-diagrams 103-1 - 103-n, 203-1 - 203-3, 303-1 - 303-6, 403-1 - 403-6, 503-1 - 503-6, 603-1 - 603-6 is assigned a predetermined position in the diagram arrangement 105, displaying S4 at least one of the sub-diagrams 103-1 - 103-n, 203-1 - 203-3, 303-1 - 303-6, 403-1 - 403-6, 503-1 - 503-6, 603-1 - 603-6 arranged in the diagram arrangement 105, receiving S5 user input 111 with regard to the diagram arrangement 105, and controlling S6 the displaying of the diagram arrangement 105 according to the user input 111.

The diagram arrangement 105 may for example, comprises predetermined diagram positions, and each of the sub-diagrams 103-1 - 103-n, 203-1 - 203-3, 303-1 - 303-6, 403-1 - 403-6, 503-1 - 503-6, 603-1 - 603-6 may be assigned to one of the predetermined diagram positions.

The signal 110 may comprise at least three characterizing signal levels, like for example a PAM-3 signal. At least one of the sub-diagrams 103-1 - 103-n, 203-1 - 203-3, 303-1 - 303-6, 403-1 - 403-6, 503-1 - 503-6, 603-1 - 603-6 may in such cases be determined for a signal level change that is greater than a single level step in the received signal 110. With a PAM-3 signal, such a signal step would be a 0-2 signal step that skips level 2.

Displaying S4 may comprise displaying at least one sub-diagram 103-1 - 103-n, 203-1 - 203-3, 303-1 - 303-6, 403-1 - 403-6, 503-1 - 503-6, 603-1 - 603-6 comprising an eye-diagram and at least one sub-diagram 103-1 - 103-n, 203-1 - 203-3, 303-1 - 303-6, 403-1 - 403-6, 503-1 - 503-6, 603-1 - 603-6 comprising a histogram 625-1, 625-2, 623-3, 625-4, 725-2, 725-4. The two sub-diagrams 103-1 - 103-n, 203-1 - 203-3, 303-1 - 303-6, 403-1 - 403-6, 503-1 - 503-6, 603-1 - 603-6 may be displayed next to each other or below each other. As explained above, more than two sub-diagrams 103-1 - 103-n, 203-1 - 203-3, 303-1 - 303-6, 403-1 - 403-6, 503-1 - 503-6, 603-1 - 603-6 may also be shown.

The diagram positions may comprise consecutive diagram positions, and consecutive positions may be assigned to sub-diagrams 103-1 - 103-n, 203-1 - 203-3, 303-1 - 303-6, 403-1 - 403-6, 503-1 - 503-6, 603-1 - 603-6 that refer to adjacent level steps in the received signal 110. In such embodiments, displaying S4 may comprise displaying the next sub-diagram 103-1 - 103-n, 203-1 - 203-3, 303-1 - 303-6, 403-1 - 403-6, 503-1 - 503-6, 603-1 - 603-6 according to the sequence of the positions upon receiving a respective user input 111.

The diagram positions may also refer to angular positions. In such embodiments, an angular position may be assigned to at least one of the sub-diagrams 103-1 - 103-n, 203-1 - 203-3, 303-1 - 303-6, 403-1 - 403-6, 503-1 - 503-6, 603-1 - 603-6. Displaying S4 may comprise displaying the sub-diagrams 103-1 - 103-n, 203-1 - 203-3, 303-1 - 303-6, 403-1 - 403-6, 503-1 - 503-6, 603-1 - 603-6 as lines in a circular diagram with a common center point based on the assigned angular positions.

Displaying S4 may comprise displaying at least two sub-diagrams 103-1 - 103-n, 203-1 - 203-3, 303-1 - 303-6, 403-1 - 403-6, 503-1 - 503-6, 603-1 - 603-6 next to each other in two sections 320-1, 320-2, 320-3, 520-1, 520-2, 520-3, 720-1, 720-2, 720-3. Further, multiple sub-diagrams 103-1 - 103-n, 203-1 - 203-3, 303-1 - 303-6, 403-1 - 403-6, 503-1 - 503-6, 603-1 - 603-6 may be overlaid in at least one of the sections 320-1, 320-2, 320-3, 520-1, 520-2, 520-3, 720-1, 720-2, 720-3.

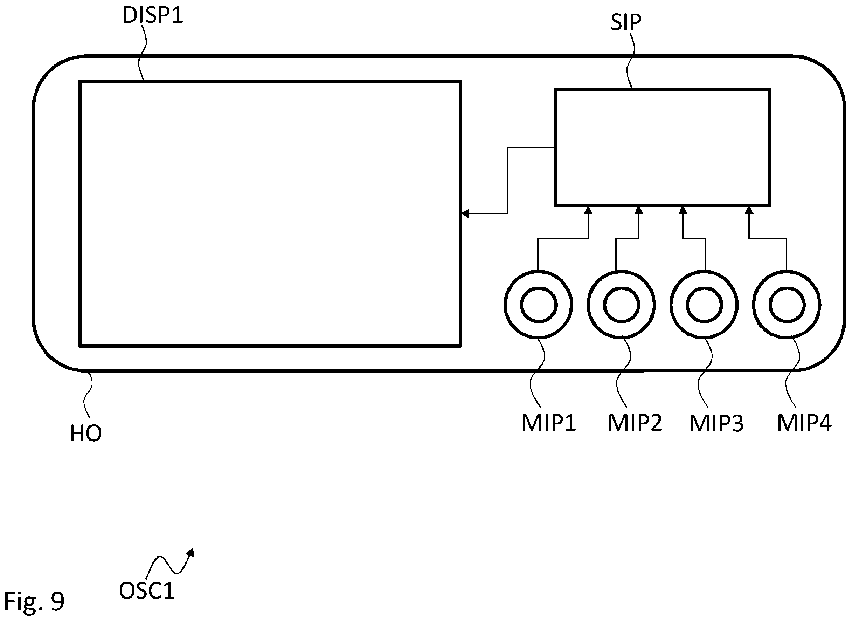

Figure 9 shows a block diagram of an oscilloscope OSC1 that may be used with an embodiment of a differential measurement probe according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user.

The elements of the measurement application device may be implemented in corresponding elements of the oscilloscope OSC1. For example, the signal interface may be implemented in the measurement inputs MIP1, MIP2, MIP3, MIP4. The signal analyzer, and the diagram processor may be implemented in the signal processor SIP. The display may be implemented in the display DISP1. Any of the user input elements (not explicitly shown) of the oscilloscope OSC1 may be used as user input for the measurement application device.

### LIST OF REFERENCE SIGNS

| | |
|---|---|
| 100 | measurement application device |
| 101 | signal interface |
| 102 | signal analyzer |
| 103-1 - 103-n | sub-diagram |
| 203-1 - 203-3 | sub-diagram |
| 303-1 - 303-6 | sub-diagram |
| 403-1 - 403-6 | sub-diagram |
| 503-1 - 503-6 | sub-diagram |
| 603-1 - 603-6 | sub-diagram |
| 104 | diagram processor |
| 105 | diagram arrangement |
| 106 | display |
| 107 | user interface |
| 110 | signal |
| 111 | user input |
| 215 | viewing direction |
| 320-1, 320-2, 320-3 | section |
| 520-1, 520-2, 520-3 | section |
| 720-1, 720-2, 720-3 | section |
| 625-1, 625-2, 623-3, 625-4 | histogram |
| 725-2, 725-4 | histogram |
| 626 - 1 - 626 - 6 | section |
| OSC1 | oscilloscope |
| HO | housing |
| MIP1, MIP2, MIP3, MIP4 | measurement input |
| SIP | signal processing |
| DISP1 | display |

## Claims

1. Measurement application device (100), comprising:
a signal interface (101) that is configured to receive a signal (110) that comprises at least two characterizing signal levels;
a signal analyzer (102) that is coupled to the signal interface (101) and that is configured to analyze the received signal (110) to determine individual sub-diagrams (103-1 - 103-n, 203-1 - 203-3, 303-1 - 303-6, 403-1 - 403-6, 503-1 - 503-6, 603-1 - 603-6) for the received signal (110), wherein each one of the sub-diagrams (103-1 - 103-n, 203-1 - 203-3, 303-1 - 303-6, 403-1 - 403-6, 503-1 - 503-6, 603-1 - 603-6) comprises a predetermined diagram type, and wherein the sub-diagrams (103-1 - 103-n, 203-1 - 203-3, 303-1 - 303-6, 403-1 - 403-6, 503-1 - 503-6, 603-1 - 603-6) at least comprise eye diagrams and/or jitter diagrams;
a display (106);
a diagram processor (104) that is coupled to the signal analyzer (102) and the display (106), and that is configured to arrange the sub-diagrams (103-1 - 103-n, 203-1 - 203-3, 303-1 - 303-6, 403-1 - 403-6, 503-1 - 503-6, 603-1 - 603-6) in a three-dimensional diagram arrangement (105), wherein each one of the sub-diagrams (103-1 - 103-n, 203-1 - 203-3, 303-1 - 303-6, 403-1 - 403-6, 503-1 - 503-6, 603-1 - 603-6) is assigned a predetermined position in the diagram arrangement (105), and to control the display (106) to display at least one of the sub-diagrams (103-1 - 103-n, 203-1 - 203-3, 303-1 - 303-6, 403-1 - 403-6, 503-1 - 503-6, 603-1 - 603-6) arranged in the diagram arrangement (105), wherein the diagram arrangement (105) is a data structure that defines the positions for the single sub-diagrams (103-1 - 103-n, 203-1 - 203-3, 303-1 - 303-6, 403-1 - 403-6, 503-1 - 503-6, 603-1 - 603-6) relative to each other; and
a user interface (107) configured to receive user input (111) with regard to the diagram arrangement (105);
wherein the diagram processor (104) is configured to control the displaying of the diagram arrangement (105) by the display (106) according to the user input (111), wherein a predefined display plane is shown to the user that is arranged with a respective relative position to the three-dimensional diagram arrangement (105).

2. Measurement application device (100) according to claim 1, wherein the signal analyzer (102) is further configured to determine the sub-diagrams (103-1 - 103-n, 203-1 - 203-3, 303-1 - 303-6, 403-1 - 403-6, 503-1 - 503-6, 603-1 - 603-6) as histograms (625-1, 625-2, 623-3, 625-4, 725-2, 725-4).

3. Measurement application device (100) according to any of the preceding claims, wherein the signal analyzer (102) is configured to determine at least one of the sub-diagrams (103-1 - 103-n, 203-1 - 203-3, 303-1 - 303-6, 403-1 - 403-6, 503-1 - 503-6, 603-1 - 603-6) for a signal level change that is greater than a single level step in the received signal (110).

4. Measurement application device (100) according to any of claims 2 and 3, wherein the diagram processor (104) is configured to control the display (106) to display at least one sub-diagram (103-1 - 103-n, 203-1 - 203-3, 303-1 - 303-6, 403-1 - 403-6, 503-1 - 503-6, 603-1 - 603-6) comprising an eye-diagram and at least one sub-diagram (103-1 - 103-n, 203-1 - 203-3, 303-1 - 303-6, 403-1 - 403-6, 503-1 - 503-6, 603-1 - 603-6) comprising a histogram (625-1, 625-2, 623-3, 625-4, 725-2, 725-4).

5. Measurement application device (100) according to any of the preceding claims, wherein the diagram positions comprise consecutive diagram positions, and wherein the diagram processor (104) is configured to assign consecutive positions to sub-diagrams (103-1 - 103-n, 203-1 - 203-3, 303-1 - 303-6, 403-1 - 403-6, 503-1 - 503-6, 603-1 - 603-6) that refer to adjacent level steps in the received signal (110); and
wherein the diagram processor (104) is configured to control the display (106) to display the next sub-diagram (103-1 - 103-n, 203-1 - 203-3, 303-1 - 303-6, 403-1 - 403-6, 503-1 - 503-6, 603-1 - 603-6) according to the sequence of the positions upon receiving a respective user input (111).

6. Measurement application device (100) according to any of the preceding claims, wherein the diagram positions refer to angular positions, and wherein the diagram processor (104) is configured to assign an angular position to at least one of the sub-diagrams (103-1 - 103-n, 203-1 - 203-3, 303-1 - 303-6, 403-1 - 403-6, 503-1 - 503-6, 603-1 - 603-6); and
wherein the diagram processor (104) is configured to control the display (106) to display the sub-diagrams (103-1 - 103-n, 203-1 - 203-3, 303-1 - 303-6, 403-1 - 403-6, 503-1 - 503-6, 603-1 - 603-6) as lines in a circular diagram with a common center point based on the assigned angular positions.

7. Measurement application device (100) according to any of the preceding claims, wherein the diagram processor (104) is configured to control the display (106) to display at least two sub-diagrams (103-1 - 103-n, 203-1 - 203-3, 303-1 - 303-6, 403-1 - 403-6, 503-1 - 503-6, 603-1 - 603-6) next to each other in two sections (320-1, 320-2, 320-3, 520-1, 520-2, 520-3, 720-1, 720-2, 720-3), and to overlay multiple sub-diagrams (103-1 - 103-n, 203-1 - 203-3, 303-1 - 303-6, 403-1 - 403-6, 503-1 - 503-6, 603-1 - 603-6) in at least one of the sections (320-1, 320-2, 320-3, 520-1, 520-2, 520-3, 720-1, 720-2, 720-3).

8. Data processing method carried out by the measurement application device (110) according to anyone of claims 1 to 7, the method comprising:
receiving (S1) a signal (110) that comprises at least two characterizing signal levels; determining (S2) individual sub-diagrams (103-1 - 103-n, 203-1 - 203-3, 303-1 - 303-6, 403-1 - 403-6, 503-1 - 503-6, 603-1 - 603-6) for the received signal (110), wherein each one of the sub-diagrams (103-1 - 103-n, 203-1 - 203-3, 303-1 - 303-6, 403-1 - 403-6, 503-1 - 503-6, 603-1 - 603-6) comprises a predetermined diagram type, and wherein the sub-diagrams (103-1 - 103-n, 203-1 - 203-3, 303-1 - 303-6, 403-1 - 403-6, 503-1 - 503-6, 603-1 - 603-6) at least comprise eye diagrams and/or jitter diagrams;
arranging (S3) the sub-diagrams (103-1 - 103-n, 203-1 - 203-3, 303-1 - 303-6, 403-1 - 403-6, 503-1 - 503-6, 603-1 - 603-6) in a three-dimensional diagram arrangement (105), wherein each one of the sub-diagrams (103-1 - 103-n, 203-1 - 203-3, 303-1 - 303-6, 403-1 - 403-6, 503-1 - 503-6, 603-1 - 603-6) is assigned a predetermined position in the diagram arrangement (105), wherein the diagram arrangement (105) is a data structure that defines the positions for the single sub-diagrams (103-1 - 103-n, 203-1 - 203-3, 303-1 - 303-6, 403-1 - 403-6, 503-1 - 503-6, 603-1 - 603-6) relative to each other;
displaying (S4) at least one of the sub-diagrams (103-1 - 103-n, 203-1 - 203-3, 303-1 - 303-6, 403-1 - 403-6, 503-1 - 503-6, 603-1 - 603-6) arranged in the diagram arrangement (105);
receiving (S5) user input (111) with regard to the diagram arrangement (105); and controlling (S6) the displaying of the diagram arrangement (105) according to the user input (111), wherein a predefined display plane is shown to the user that is arranged with a respective relative position to the three-dimensional diagram arrangement (105).

9. Data processing method according to claim 8, wherein the signal (110) comprises at least three characterizing signal levels; and
wherein at least one of the sub-diagrams (103-1 - 103-n, 203-1 - 203-3, 303-1 - 303-6, 403-1 - 403-6, 503-1 - 503-6, 603-1 - 603-6) is determined for a signal level change that is greater than a single level step in the received signal (110).

10. Data processing method according to anyone of claims 8 to 9, wherein displaying (S4) comprises displaying at least one sub-diagram (103-1 - 103-n, 203-1 - 203-3, 303-1 - 303-6, 403-1 - 403-6, 503-1 - 503-6, 603-1 - 603-6) comprising an eye-diagram and at least one sub-diagram (103-1 - 103-n, 203-1 - 203-3, 303-1 - 303-6, 403-1 - 403-6, 503-1 - 503-6, 603-1 - 603-6) comprising a histogram (625-1, 625-2, 623-3, 625-4, 725-2, 725-4).

11. Data processing method according to anyone of claims 8 to 10,
wherein the diagram positions comprise consecutive diagram positions, and wherein consecutive positions are assigned to sub-diagrams (103-1 - 103-n, 203-1 - 203-3, 303-1 - 303-6, 403-1 - 403-6, 503-1 - 503-6, 603-1 - 603-6) that refer to adjacent level steps in the received signal (110); and
wherein displaying (S4) comprises displaying the next sub-diagram (103-1 - 103-n, 203-1 - 203-3, 303-1 - 303-6, 403-1 - 403-6, 503-1 - 503-6, 603-1 - 603-6) according to the sequence of the positions upon receiving a respective user input (111).

12. Data processing method according to anyone of claims 8 to 11,
wherein the diagram positions refer to angular positions, and an angular position is assigned to at least one of the sub-diagrams (103-1 - 103-n, 203-1 - 203-3, 303-1 - 303-6, 403-1 - 403-6, 503-1 - 503-6, 603-1 - 603-6); and
wherein displaying (S4) comprises displaying the sub-diagrams (103-1 - 103-n, 203-1 - 203-3, 303-1 - 303-6, 403-1 - 403-6, 503-1 - 503-6, 603-1 - 603-6) as lines in a circular diagram with a common center point based on the assigned angular positions.

13. Data processing method according to anyone of claims 8 to 12, wherein displaying (S4) may comprise to display at least two sub-diagrams (103-1 - 103-n, 203-1 - 203-3, 303-1 - 303-6, 403-1 - 403-6, 503-1 - 503-6, 603-1 - 603-6) next to each other in two sections (320-1, 320-2, 320-3, 520-1, 520-2, 520-3, 720-1, 720-2, 720-3), and to overlay multiple sub-diagrams (103-1 - 103-n, 203-1 - 203-3, 303-1 - 303-6, 403-1 - 403-6, 503-1 - 503-6, 603-1 - 603-6) in at least one of the sections (320-1, 320-2, 320-3, 520-1, 520-2, 520-3, 720-1, 720-2, 720-3).

## Patentansprüche

1. Messanwendungsvorrichtung (100), umfassend:
eine Signalschnittstelle (101), die konfiguriert ist, um ein Signal (110) zu empfangen, das mindestens zwei kennzeichnende Signalpegel umfasst;
einen Signalanalysator (102), der mit der Signalschnittstelle (101) gekoppelt ist und der konfiguriert ist, um das empfangene Signal (110) zu analysieren, um individuelle Teildiagramme (103-1-103-n, 203-1-203-3, 303-1-303-6, 403-1-403-6, 503-1-503-6, 603-1-603-6) für das empfangene Signal (110) zu bestimmen, wobei jedes der Teildiagramme (103-1-103-n, 203-1-203-3, 303-1-303-6, 403-1-403-6, 503-1-503-6, 603-1-603-6) eine vorbestimmte Diagrammart umfasst und wobei die Teildiagramme (103-1-103-n, 203-1-203-3, 303-1-303-6, 403-1-403-6, 503-1-503-6, 603-1-603-6) mindestens Augendiagramme und/oder Jitter-Diagramme umfassen;
eine Anzeige (106);
einen Diagrammprozessor (104), der mit dem Signalanalysator (102) und der Anzeige (106) gekoppelt ist und der konfiguriert ist, um die Teildiagramme (103-1-103-n, 203-1-203-3, 303-1-303-6, 403-1-403-6, 503-1-503-6, 603-1-603-6) in einer dreidimensionalen Diagrammanordnung (105) anzuordnen, wobei jedem der Teildiagramme (103-1-103-n, 203-1-203-3, 303-1-303-6, 403-1-403-6, 503-1-503-6, 603-1-603-6) eine vorbestimmte Position in der Diagrammanordnung (105) zugewiesen ist, und um die Anzeige (106) zu steuern, um mindestens eines der in der Diagrammanordnung (105) angeordneten Teildiagramme (103-1-103-n, 203-1-203-3, 303-1-303-6, 403-1-403-6, 503-1-503-6, 603-1-603-6) anzuzeigen, wobei die Diagrammanordnung (105) eine Datenstruktur ist, die die Positionen für die einzelnen Teildiagramme (103-1-103-n, 203-1-203-3, 303-1-303-6, 403-1-403-6, 503-1-503-6, 603-1-603-6) relativ zueinander definiert; und
eine Benutzerschnittstelle (107), die konfiguriert ist, um eine Benutzereingabe (111) hinsichtlich der Diagrammanordnung (105) zu empfangen;
wobei der Diagrammprozessor (104) konfiguriert ist, um das Anzeigen der Diagrammanordnung (105) durch die Anzeige (106) gemäß der Benutzereingabe (111) zu steuern,
wobei dem Benutzer eine vordefinierte Anzeigeebene gezeigt wird, die mit einer jeweiligen relativen Position zu der dreidimensionalen Diagrammanordnung (105) angeordnet ist.

2. Messanwendungsvorrichtung (100) nach Anspruch 1,
wobei der Signalanalysator (102) ferner konfiguriert ist, um die Teildiagramme (103-1-103-n, 203-1-203-3, 303-1-303-6, 403-1-403-6, 503-1-503-6, 603-1-603-6) als Histogramme (625-1,625-2, 623-3, 625-4, 725-2, 725-4) zu bestimmen.

3. Messanwendungsvorrichtung (100) nach einem der vorstehenden Ansprüche, wobei der Signalanalysator (102) konfiguriert ist, um mindestens eines der Teildiagramme (103-1-103-n, 203-1-203-3, 303-1-303-6, 403-1-403-6, 503-1-503-6, 603-1-603-6) für eine Signalpegeländerung zu bestimmen, die größer als eine einzelne Pegelstufe in dem empfangenen Signal (110) ist.

4. Messanwendungsvorrichtung (100) nach einem der Ansprüche 2 und 3,
wobei der Diagrammprozessor (104) konfiguriert ist, um die Anzeige (106) zu steuern, um mindestens ein Teildiagramm (103-1-103-n, 203-1-203-3, 303-1-303-6, 403-1-403-6, 503-1-503-6, 603-1-603-6), umfassend ein Augendiagramm, und mindestens ein Teildiagramm (103-1-103-n, 203-1-203-3, 303-1-303-6, 403-1-403-6, 503-1-503-6, 603-1-603-6), umfassend ein Histogramm (625-1,625-2, 623-3, 625-4, 725-2, 725-4), anzuzeigen.

5. Messanwendungsvorrichtung (100) nach einem der vorstehenden Ansprüche, wobei die Diagrammpositionen aufeinanderfolgende Diagrammpositionen umfassen und wobei der Diagrammprozessor (104) konfiguriert ist, um Teildiagrammen (103-1-103-n, 203-1-203-3, 303-1-303-6, 403-1-403-6, 503-1-503-6, 603-1-603-6), die sich auf angrenzende Pegelstufen in dem empfangenen Signal (110) beziehen, aufeinanderfolgende Positionen zuzuweisen; und
wobei der Diagrammprozessor (104) konfiguriert ist, um die Anzeige (106) zu steuern, um bei Empfang einer jeweiligen Benutzereingabe (111) das nächste Teildiagramm (103-1-103-n, 203-1-203-3, 303-1-303-6, 403-1-403-6, 503-1-503-6, 603-1-603-6) gemäß der Reihenfolge der Positionen anzuzeigen.

6. Messanwendungsvorrichtung (100) nach einem der vorstehenden Ansprüche, wobei sich die Diagrammpositionen auf Winkelpositionen beziehen und wobei der Diagrammprozessor (104) konfiguriert ist, um mindestens einem der Teildiagramme (103-1-103-n, 203-1-203-3, 303-1-303-6, 403-1-403-6, 503-1-503-6, 603-1-603-6) eine Winkelposition zuzuweisen; und
wobei der Diagrammprozessor (104) konfiguriert ist, um die Anzeige (106) zu steuern, um die Teildiagramme (103-1-103-n, 203-1-203-3, 303-1-303-6, 403-1-403-6, 503-1-503-6, 603-1-603-6) als Linien in einem kreisförmigen Diagramm mit einem gemeinsamen Mittelpunkt basierend auf den zugewiesenen Winkelpositionen anzuzeigen.

7. Messanwendungsvorrichtung (100) nach einem der vorstehenden Ansprüche, wobei der Diagrammprozessor (104) konfiguriert ist, um die Anzeige (106) zu steuern, um mindestens zwei Teildiagramme (103-1-103-n, 203-1-203-3, 303-1-303-6, 403-1-403-6, 503-1-503-6, 603-1-603-6) nebeneinander in zwei Abschnitten (320-1, 320-2, 320-3, 520-1,520-2, 520-3, 720-1,720-2, 720-3) anzuzeigen und mehrere Teildiagramme (103-1-103-n, 203-1-203-3, 303-1-303-6, 403-1-403-6, 503-1-503-6, 603-1-603-6) in mindestens einem der Abschnitte (320-1,320-2, 320-3, 520-1,520-2, 520-3, 720-1,720-2, 720-3) zu überlagern.

8. Datenverarbeitungsverfahren, das durch die Messanwendungsvorrichtung (110) nach einem der Ansprüche 1 bis 7 ausgeführt wird, das Verfahren umfassend:
Empfangen (S1) eines Signals (110), das mindestens zwei kennzeichnende Signalpegel umfasst; Bestimmen (S2) individueller Teildiagramme (103-1-103-n, 203-1-203-3, 303-1-303-6, 403-1-403-6, 503-1-503-6, 603-1-603-6) für das empfangene Signal (110), wobei jedes der Teildiagramme (103-1-103-n, 203-1-203-3, 303-1-303-6, 403-1-403-6, 503-1-503-6, 603-1-603-6) eine vorbestimmte Diagrammart umfasst und wobei die Teildiagramme (103-1-103-n, 203-1-203-3, 303-1-303-6, 403-1-403-6, 503-1-503-6, 603-1-603-6) mindestens Augendiagramme und/oder Jitter-Diagramme umfassen;
Anordnen (S3) der Teildiagramme (103-1-103-n, 203-1-203-3, 303-1-303-6, 403-1-403-6, 503-1-503-6, 603-1-603-6) in einer dreidimensionalen Diagrammanordnung (105), wobei jedem der Teildiagramme (103-1-103-n, 203-1-203-3, 303-1-303-6, 403-1-403-6, 503-1-503-6, 603-1-603-6) eine vorbestimmte Position in der Diagrammanordnung (105) zugewiesen wird, wobei die Diagrammanordnung (105) eine Datenstruktur ist, die die Positionen für die einzelnen Teildiagramme (103-1-103-n, 203-1-203-3, 303-1-303-6, 403-1-403-6, 503-1-503-6, 603-1-603-6) relativ zueinander definiert;
Anzeigen (S4) mindestens eines der in der Diagrammanordnung (105) angeordneten Teildiagramme (103-1-103-n, 203-1-203-3, 303-1-303-6, 403-1-403-6, 503-1-503-6, 603-1-603-6);
Empfangen (S5) einer Benutzereingabe (111) hinsichtlich der Diagrammanordnung (105); und
Steuern (S6) der Anzeige der Diagrammanordnung (105) gemäß der Benutzereingabe (111), wobei dem Benutzer eine vordefinierte Anzeigeebene gezeigt wird, die mit einer jeweiligen relativen Position zu der dreidimensionalen Diagrammanordnung (105) angeordnet ist.

9. Datenverarbeitungsverfahren nach Anspruch 8, wobei das Signal (110) mindestens drei kennzeichnende Signalpegel umfasst; und
wobei mindestens eines der Teildiagramme (103-1-103-n, 203-1-203-3, 303-1-303-6, 403-1-403-6, 503-1-503-6, 603-1-603-6) für eine Signalpegeländerung bestimmt wird, die größer als eine einzelne Pegelstufe in dem empfangenen Signal (110) ist.

10. Datenverarbeitungsverfahren nach einem der Ansprüche 8 bis 9,
wobei das Anzeigen (S4) das Anzeigen mindestens eines Teildiagramms (103-1-103-n, 203-1-203-3, 303-1-303-6, 403-1-403-6, 503-1-503-6, 603-1-603-6), umfassend ein Augendiagramm, und mindestens eines Teildiagramms (103-1-103-n, 203-1-203-3, 303-1-303-6, 403-1-403-6, 503-1-503-6, 603-1-603-6), umfassend ein Histogramm (625-1,625-2, 623-3, 625-4, 725-2, 725-4), umfasst.

11. Datenverarbeitungsverfahren nach einem der Ansprüche 8 bis 10,
wobei die Diagrammpositionen aufeinanderfolgende Diagrammpositionen umfassen und wobei aufeinanderfolgende Positionen Teildiagrammen (103-1-103-n, 203-1-203-3, 303-1-303-6, 403-1-403-6, 503-1-503-6, 603-1-603-6) zugewiesen werden, die sich auf angrenzende Pegelstufen in dem empfangenen Signal (110) beziehen; und
wobei das Anzeigen (S4) das Anzeigen des nächsten Teildiagramms (103-1-103-n, 203-1-203-3, 303-1-303-6, 403-1-403-6, 503-1-503-6, 603-1-603-6) gemäß der Reihenfolge der Positionen bei Empfang einer jeweiligen Benutzereingabe (111) umfasst.

12. Datenverarbeitungsverfahren nach einem der Ansprüche 8 bis 11, wobei sich die Diagrammpositionen auf Winkelpositionen beziehen und mindestens einem der Teildiagramme (103-1-103-n, 203-1-203-3, 303-1-303-6, 403-1-403-6, 503-1-503-6, 603-1-603-6) eine Winkelposition zugeordnet wird; und
wobei das Anzeigen (S4) das Anzeigen der Teildiagramme (103-1-103-n, 203-1-203-3, 303-1-303-6, 403-1-403-6, 503-1-503-6, 603-1-603-6) als Linien in einem kreisförmigen Diagramm mit einem gemeinsamen Mittelpunkt basierend auf den zugewiesenen Winkelpositionen umfasst.

13. Datenverarbeitungsverfahren nach einem der Ansprüche 8 bis 12,
wobei das Anzeigen (S4) umfassen kann, mindestens zwei Teildiagramme (103-1-103-n, 203-1-203-3, 303-1-303-6, 403-1-403-6, 503-1-503-6, 603-1-603-6) nebeneinander in zwei Abschnitten (320-1,320-2, 320-3, 520-1,520-2, 520-3, 720-1,720-2, 720-3) anzuzeigen und mehrere Teildiagramme (103-1-103-n, 203-1-203-3, 303-1-303-6, 403-1-403-6, 503-1-503-6, 603-1-603-6) in mindestens einem der Abschnitte (320-1,320-2, 320-3, 520-1,520-2, 520-3, 720-1,720-2, 720-3) zu überlagern.

## Revendications

1. Dispositif d'application de mesure (100), comprenant :
une interface de signal (101) qui est configurée pour recevoir un signal (110) qui comprend au moins deux niveaux de signal de caractérisation ;
un analyseur de signal (102) qui est couplé à l'interface de signal (101) et qui est configuré pour analyser le signal (110) reçu afin de déterminer des sous-diagrammes (103-1-103-n, 203-1-203-3, 303-1-303-6, 403-1-403-6, 503-1-503-6, 603-1-603-6) individuels pour le signal (110) reçu, dans lequel chacun des sous-diagrammes (103-1-103-n, 203-1-203-3, 303-1-303-6, 403-1-403-6, 503-1-503-6, 603-1-603-6) comprend un type de diagramme prédéterminé, et dans lequel les sous-diagrammes (103-1-103-n, 203-1-203-3, 303-1-303-6, 403-1-403-6, 503-1-503-6, 603-1-603-6) comprennent au moins des diagrammes de l'œil et/ou des diagrammes de gigue ;
un dispositif d'affichage (106) ;
un processeur de diagramme (104) qui est couplé à l'analyseur de signal (102) et au dispositif d'affichage (106), et qui est configuré pour agencer les sous-diagrammes (103-1-103-n, 203-1-203-3, 303-1-303-6, 403-1-403-6, 503-1-503-6, 603-1-603-6) dans un agencement de diagramme (105) tridimensionnel, dans lequel chacun des sous-diagrammes (103-1-103-n, 203-1-203-3, 303-1-303-6, 403-1-403-6, 503-1-503-6, 603-1-603-6) se voit attribuer une position prédéterminée dans l'agencement de diagramme (105), et pour commander le dispositif d'affichage (106) afin d'afficher au moins l'un parmi les sous-diagrammes (103-1-103-n, 203-1-203-3, 303-1-303-6, 403-1-403-6, 503-1-503-6, 603-1-603-6) agencés dans l'agencement de diagramme (105), dans lequel l'agencement de diagramme (105) est une structure de données qui définit les positions pour les sous-diagrammes (103-1-103-n, 203-1-203-3, 303-1-303-6, 403-1-403-6, 503-1-503-6, 603-1-603-6) uniques les uns par rapport aux autres ; et
une interface utilisateur (107) configurée pour recevoir une entrée utilisateur (111) en ce qui concerne l'agencement de diagramme (105) ;
dans lequel le processeur de diagramme (104) est configuré pour commander l'affichage de l'agencement de diagramme (105) par le dispositif d'affichage (106) selon l'entrée utilisateur (111),
dans lequel un plan d'affichage prédéfini est montré à l'utilisateur, qui est agencé avec une position relative respective par rapport à l'agencement de diagramme (105) tridimensionnel.

2. Dispositif d'application de mesure (100) selon la revendication 1,
dans lequel l'analyseur de signal (102) est en outre configuré pour déterminer les sous-diagrammes (103-1-103-n, 203-1-203-3, 303-1-303-6, 403-1-403-6, 503-1-503-6, 603-1-603-6) comme histogrammes (625-1, 625-2, 623-3, 625-4, 725-2, 725-4).

3. Dispositif d'application de mesure (100) selon l'une quelconque des revendications précédentes, dans lequel l'analyseur de signal (102) est configuré pour déterminer au moins l'un parmi les sous-diagrammes (103-1-103-n, 203-1-203-3, 303-1-303-6, 403-1-403-6, 503-1-503-6, 603-1-603-6) pour un changement de niveau de signal qui est supérieur à un palier de niveau unique dans le signal (110) reçu.

4. Dispositif d'application de mesure (100) selon l'une quelconque des revendications 2 et 3,
dans lequel le processeur de diagramme (104) est configuré pour commander le dispositif d'affichage (106) afin d'afficher au moins un sous-diagramme (103-1-103-n, 203-1-203-3, 303-1-303-6, 403-1-403-6, 503-1-503-6, 603-1-603-6) comprenant un diagramme de l'œil et au moins un sous-diagramme (103-1-103-n, 203-1-203-3, 303-1-303-6, 403-1-403-6, 503-1-503-6, 603-1-603-6) comprenant un histogramme (625-1, 625-2, 623-3, 625-4, 725-2, 725-4).

5. Dispositif d'application de mesure (100) selon l'une quelconque des revendications précédentes, dans lequel les positions de diagramme comprennent des positions de diagramme consécutives, et dans lequel le processeur de diagramme (104) est configuré pour attribuer des positions consécutives à des sous-diagrammes (103-1-103-n, 203-1-203-3, 303-1-303-6, 403-1-403-6, 503-1-503-6, 603-1-603-6) qui se réfèrent à des paliers de niveau adjacents dans le signal (110) reçu ; et
dans lequel le processeur de diagramme (104) est configuré pour commander le dispositif d'affichage (106) afin d'afficher le sous-diagramme (103-1-103-n, 203-1-203-3, 303-1-303-6, 403-1-403-6, 503-1-503-6, 603-1-603-6) suivant selon la séquence des positions lors de la réception d'une entrée utilisateur (111) respective.

6. Dispositif d'application de mesure (100) selon l'une quelconque des revendications précédentes, dans lequel les positions de diagramme se réfèrent à des positions angulaires, et dans lequel le processeur de diagramme (104) est configuré pour attribuer une position angulaire à au moins l'un parmi les sous-diagrammes (103-1-103-n, 203-1-203-3, 303-1-303-6, 403-1-403-6, 503-1-503-6, 603-1-603-6) ; et
dans lequel le processeur de diagramme (104) est configuré pour commander le dispositif d'affichage (106) afin d'afficher les sous-diagrammes (103-1-103-n, 203-1-203-3, 303-1-303-6, 403-1-403-6, 503-1-503-6, 603-1-603-6) comme lignes dans un diagramme circulaire avec un point central commun sur la base des positions angulaires attribuées.

7. Dispositif d'application de mesure (100) selon l'une quelconque des revendications précédentes, dans lequel le processeur de diagramme (104) est configuré pour commander le dispositif d'affichage (106) afin d'afficher au moins deux sous-diagrammes (103-1-103-n, 203-1-203-3, 303-1-303-6, 403-1-403-6, 503-1-503-6, 603-1-603-6) l'un à côté de l'autre dans deux sections (320-1, 320-2, 320-3, 520-1,520-2, 520-3, 720-1, 720-2, 720-3), et pour superposer de multiples sous-diagrammes (103-1-103-n, 203-1-203-3, 303-1-303-6, 403-1-403-6, 503-1-503-6, 603-1-603-6) dans au moins l'une parmi les sections (320-1, 320-2, 320-3, 520-1, 520-2, 520-3, 720-1, 720-2, 720-3).

8. Procédé de traitement de données effectué par le dispositif d'application de mesure (110) selon l'une quelconque des revendications 1 à 7, le procédé comprenant :
la réception (S1) d'un signal (110) qui comprend au moins deux niveaux de signal de caractérisation ; la détermination (S2) de sous-diagrammes (103-1-103-n, 203-1-203-3, 303-1-303-6, 403-1-403-6, 503-1-503-6, 603-1-603-6) individuels pour le signal (110) reçu, dans lequel chacun des sous-diagrammes (103-1-103-n, 203-1-203-3, 303-1-303-6, 403-1-403-6, 503-1-503-6, 603-1-603-6) comprend un type de diagramme prédéterminé, et dans lequel les sous-diagrammes (103-1-103-n, 203-1-203-3, 303-1-303-6, 403-1-403-6, 503-1-503-6, 603-1-603-6) comprennent au moins des diagrammes de l'œil et/ou des diagrammes de gigue ;
l'agencement (S3) des sous-diagrammes (103-1-103-n, 203-1-203-3, 303-1-303-6, 403-1-403-6, 503-1-503-6, 603-1-603-6) dans un agencement de diagramme (105) tridimensionnel, dans lequel chacun des sous-diagrammes (103-1-103-n, 203-1-203-3, 303-1-303-6, 403-1-403-6, 503-1-503-6, 603-1-603-6) se voit attribuer une position prédéterminée dans l'agencement de diagramme (105), dans lequel l'agencement de diagramme (105) est une structure de données qui définit les positions pour les sous-diagrammes (103-1-103-n, 203-1-203-3, 303-1-303-6, 403-1-403-6, 503-1-503-6, 603-1-603-6) uniques l'un par rapport à l'autre ;
l'affichage (S4) d'au moins l'un parmi les sous-diagrammes (103-1-103-n, 203-1-203-3, 303-1-303-6, 403-1-403-6, 503-1-503-6, 603-1-603-6) agencés dans l'agencement de diagramme (105) ;
la réception (S5) d'une entrée utilisateur (111) en ce qui concerne l'agencement de diagramme (105) ; et
la commande (S6) de l'affichage de l'agencement de diagramme (105) selon l'entrée utilisateur (111), dans lequel un plan d'affichage prédéfini est montré à l'utilisateur qui est agencé avec une position relative respective par rapport à l'agencement de diagramme (105) tridimensionnel.

9. Procédé de traitement de données selon la revendication 8, dans lequel le signal (110) comprend au moins trois niveaux de signal de caractérisation ; et
dans lequel au moins l'un parmi les sous-diagrammes (103-1-103-n, 203-1-203-3, 303-1-303-6, 403-1-403-6, 503-1-503-6, 603-1-603-6) est déterminé pour un changement de niveau de signal qui est supérieur à un palier de niveau unique dans le signal (110) reçu.

10. Procédé de traitement de données selon l'une quelconque des revendications 8 à 9,
dans lequel le dispositif d'affichage (S4) comprend l'affichage d'au moins un sous-diagramme (103-1-103-n, 203-1-203-3, 303-1-303-6, 403-1-403-6, 503-1-503-6, 603-1-603-6) comprenant un diagramme de l'œil et au moins un sous-diagramme (103-1-103-n, 203-1-203-3, 303-1-303-6, 403-1-403-6, 503-1-503-6, 603-1-603-6) comprenant un histogramme (625-1, 625-2, 623-3, 625-4, 725-2, 725-4).

11. Procédé selon l'une quelconque des revendications 8 à 10,
dans lequel les positions de diagramme comprennent des positions de diagramme consécutives, et dans lequel des positions consécutives sont attribuées à des sous-diagrammes (103-1-103-n, 203-1-203-3, 303-1-303-6, 403-1-403-6, 503-1-503-6, 603-1-603-6) qui se réfèrent à des paliers de niveau adjacents dans le signal (110) reçu ; et
dans lequel l'affichage (S4) comprend l'affichage du sous-diagramme (103-1-103-n, 203-1-203-3, 303-1-303-6, 403-1-403-6, 503-1-503-6, 603-1-603-6) suivant selon la séquence des positions lors de la réception d'une entrée utilisateur (111) respective.

12. Procédé de traitement de données selon l'une quelconque des revendications 8 à 11, dans lequel les positions de diagramme font référence à des positions angulaires, et une position angulaire est attribuée à l'au moins un parmi les sous-diagrammes (103-1-103-n, 203-1-203-3, 303-1-303-6, 403-1-403-6, 503-1-503-6, 603-1-603-6) ; et
dans lequel l'affichage (S4) comprend l'affichage des sous-diagrammes (103-1-103-n, 203-1-203-3, 303-1-303-6, 403-1-403-6, 503-1-503-6, 603-1-603-6) comme lignes dans un diagramme circulaire avec un point central commun sur la base des positions angulaires attribuées.

13. Procédé de traitement de données selon l'une quelconque des revendications 8 à 12,
dans lequel l'affichage (S4) peut comprendre l'affichage d'au moins deux sous-diagrammes (103-1-103-n, 203-1-203-3, 303-1-303-6, 403-1-403-6, 503-1-503-6, 603-1-603-6) l'un à côté de l'autre dans deux sections (320-1,320-2, 320-3, 520-1,520-2, 520-3, 720-1,720-2, 720-3), et la superposition de multiples sous-diagrammes (103-1-103-n, 203-1-203-3, 303-1-303-6, 403-1-403-6, 503-1-503-6, 603-1-603-6) dans au moins l'une parmi les sections (320-1, 320-2, 320-3, 520-1, 520-2, 520-3, 720-1, 720-2, 720-3).
